# EUROPEAN PATENT APPLICATION

(11) **EP 4 651 384 A1**
(43) Date of publication of application: **19.11.2025**
(21) Application number: 25175864.5
(22) Date of filing: 12.05.2025
(51) Int. Cl.: H03M 13/11, G06N 3/0895, H03M 13/37, H04L 1/00, H03M 13/09

(54) **SELF-ADAPTING LOW-DENSITY PARITY CHECK (LDPC) DECODER ARCHITECTURE**

(30) Priority: 13.05.2024 US 202418662059
(71) Applicant: INTEL Corporation, Santa Clara, CA 95054 (US)
(72) Inventor: Chautru, Nic, SANTA CLARA, 95051 (US)
(74) Representative: 2SPL Patentanwälte PartG mbB

(57) **Abstract**

A low-density parity check (LDPC) decoder architecture is provided for a self-adapting an LDPC control input that is used to successfully decode corresponding received code blocks. The architecture enables a machine-learning based process that facilitates learning of optimal LDPC control inputs, such as log-likelihood (LLR) terms scaling, that is required for a given channel condition and deployment scenario. This is achieved by gathering, as a background process, *a posteriori* decoding metrics via unused LDPC decoder accelerators, which function to process the labelled LLR data sets for different LDPC control input values. Then, such optimal LDPC control input estimates may be applied to the real-time LDPC decoding based on previous learning across UE/channel conditions.

## Description

### TECHNICAL FIELD

The disclosure described herein generally relates to the use of a self-adapting low-density parity check (LDPC) decoder architecture and, more particularly, to the use of a self-adaptive and learning architecture that enables LDPC decoder control inputs to be improved over time using *a posteriori* decoding metrics from unused LDPC decoder accelerators.

### BACKGROUND

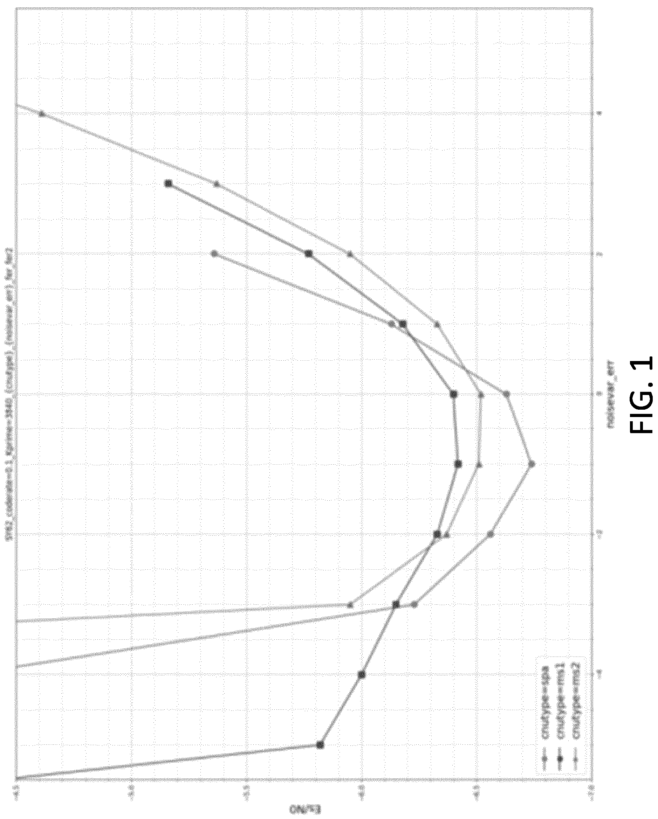

LDPC decoder algorithms use non-linear iterative decoding algorithms, which causes their performance to be directly dependent on an accurate scaling of the input log-likelihood ratio (LLR) terms that are provided. For instance, FIG. 1 illustrates how LLR under-scaling or over-scaling of LLR terms manifests in a wireless performance degradation, which can be on the order of ~1.0 dB with different magnitudes for different variants of LDPC decoder algorithms. Thus, although an optimal scaling of LLR terms exists for LDPC decoding, obtaining this optimal scaling is in practice difficult to achieve, which in turn causes wireless performance degradation. As a result, LLR scaling algorithms, as well as LDPC decoding algorithms in general, are inadequate to meet industry and consumer demands.

### BRIEF DESCRIPTION OF THE DRAWINGS/FIGURES

The accompanying drawings, which are incorporated herein and form a part of the specification, illustrate the present disclosure and, together with the description, further serve to explain the principles and to enable a person skilled in the pertinent art to make and use the implementations as discussed herein.
FIG. 1 illustrates a plot showing the sensitivity of an LDPC decoder variant as a function of LLR scaling;
FIG. 2 illustrates a block diagram of a self-adapting LDPC decoding architecture, in accordance with the disclosure;
FIG. 3 illustrates a timeline associated with the decoding operations performed by an LDPC decoder, in accordance with the disclosure;
FIG. 4 illustrates a timeline associated with the decoding operations performed by an LDPC decoder and a training process for an LDPC decoder control input model, in accordance with the disclosure;
FIG. 5 illustrates a device, in accordance with the disclosure; and
FIG. 6 illustrates a process flow, in accordance with the disclosure.

The present disclosure will be described with reference to the accompanying drawings. The drawing in which an element first appears is typically indicated by the leftmost digit(s) in the corresponding reference number.

### DETAILED DESCRIPTION

In the following description, numerous specific details are set forth in order to provide a thorough understanding of the present disclosure. However, it will be apparent to those skilled in the art that the implementations of the disclosure, including structures, systems, and methods, may be practiced without these specific details. The description and representation herein are the common means used by those experienced or skilled in the art to most effectively convey the substance of their work to others skilled in the art. In other instances, well-known methods, procedures, components, and circuitry have not been described in detail to avoid unnecessarily obscuring the disclosure.

### I. Technical overview of low-density parity check (LDPC) decoders

Receiver error correction systems have the ability to detect errors introduced during wireless signal transmissions and to reconstruct the original data without these errors. Such systems generally function using error-correcting codes (ECCs) that are encoded in the data as part of a data transmission, which may be with respect to each bit in a series of bits constituting a code block that is part of an encoded code word. A receiver then decodes the received code blocks to generate data that was "most likely" transmitted. Such codes are designed such that a significant level (i.e. a highly unlikely) amount of noise would need to be present for the receiver to misinterpret the data if the code is correctly decoded. One such ECC technique is known as the low-density parity check (LDPC) code. The LDPC code comprises an error correcting code that increases the efficiency of transmitting data over a noisy channel. Although LDPC and other error correcting codes cannot guarantee a perfect reconstruction of a transmitted signal, the probability of lost information can be significantly reduced via their use.

LDPC decoders thus function to decode encoded LDPC codes (also referred to herein as code words, which include several code blocks) for error verification purposes. To do so, LDPC decoders receive a set of LLR (log likelihood ratio) terms, with each term representing an encoded value of any suitable number of bits, such as 8 for example. Each LLR term indicates a corresponding likelihood of each bit in a code block of a received message being a '1' or a "0." A scaling factor is then applied to each LLR term in received code block, and this process is repeated over successively received code blocks to reconstruct the code word used by the transmitter when transmitting the encoded data.

For instance, each code block may have a corresponding sequence of LLR terms, each corresponding to an individual bit in the code block. The scaling factor may represent a scalar value that is applied to the entire sequence of LLR terms to yield a scaled set of LLR terms that are received by the LDPC decoder and used for the decoding process. The LDPC decoder may perform an iterative process using each of the scaled LLR terms for a particular code block to decode the code block. The code word may represent a concatenation of all code blocks with respect to a particular encoded data transmission. The scaling of the LLR terms thus impacts the likelihood of each bit in a received code block representing a '1' or a "0," and in turn affects the efficiency of the LDPC decoder, for example by increasing or decreasing the number of required iterations needed to decode each code block.

As is generally known, the numerical generation of LLR terms is typically computed in a demapper based on an estimation of channel noise and a distance between IQ demodulated data constellation points. Consequently, the LLR scaling accuracy is directly linked to the noise variance estimation accuracy post minimum mean square error (MMSE)/maximum likelihood detector (MLD). As a result, a sensitivity of actual wireless performance to the accuracy of the LLR scaling accuracy exists, and is dependent on different signal processing algorithm variants. In practice, optimal scaling depends on channel and UE conditions, receiver gain implementations, and the LDPC decoder algorithm variant. However, even with best efforts, conventional estimation of LLR scaling cannot be guaranteed to be optimal for all channel conditions. Thus, conventional approaches focus on improving the efficiency and accuracy of the receiver LDPC decoder algorithm itself, which is a very arduous process as all practical use cases need to be considered.

Another conventional approach includes considering a version of the LDPC decoder algorithm that may be less sensitive to scaling errors. However, such approaches only mitigate the issue at the cost of slight performance degradation (a trade-off on wireless performance for optimal scaling). Thus, this only marginally addresses the issue, as all decoding algorithms options have performance degradation due to scaling (see FIG. 1), and this prevents using optimal LDPC decoder implementations due to related trade-offs.

The disclosure addresses these issues by providing an architecture that enables a machine-learning based process that facilitates self-adapting to channel conditions by learning the optimal scaling required for various given channel conditions and deployment scenarios. This is achieved by gathering, as a background process, *a posteriori* decoding metrics via unused LDPC decoder accelerators, which function to process labelled LLR data sets for different scaling values. Then, such optimal scaling estimates may be applied to real-time LDPC decoding based on previous learning across a large set of UE/channel conditions.

Although the various techniques are discussed throughout the disclosure in the context of wireless communications, this is a non-limiting and illustrative scenario. The self-adapting LDPC decoder architecture as discussed in further detail herein may be implemented for any suitable type of communications that implement LDPC decoding processes. Such communications may include wireless communications or wired communications, such as those within any suitable type of network, the use of internet protocol (IP) data transmissions, etc.

### II. A self-adapting LDPC decoding architecture

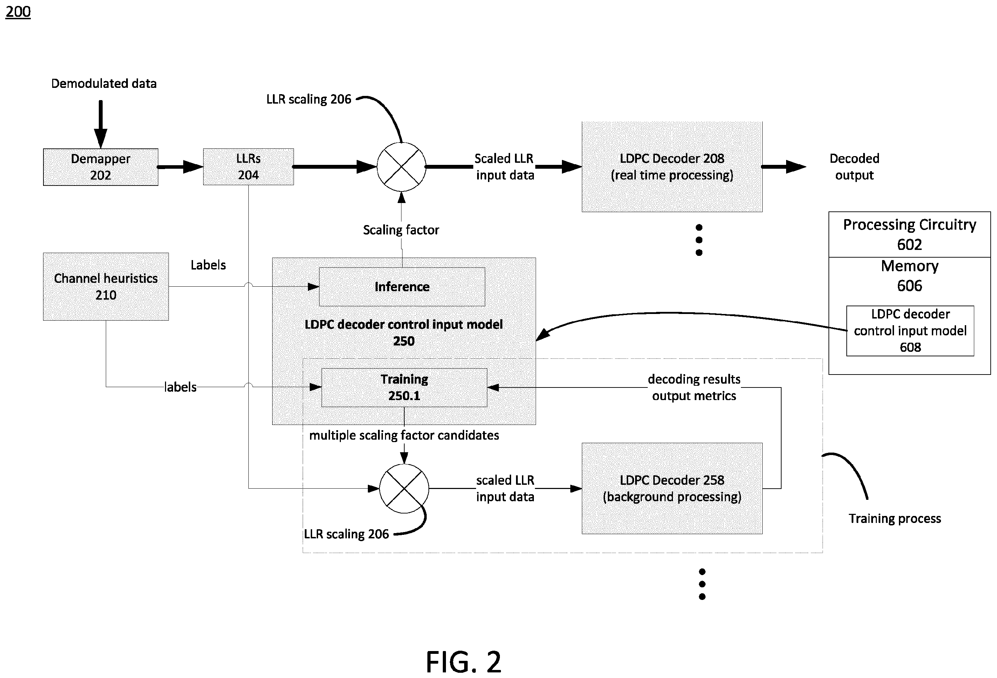

FIG. 2 illustrates a block diagram of a self-adapting LDPC decoding architecture, in accordance with the disclosure. The various blocks as shown in FIG. 2 may be identified with the execution of software, hardware components, or any suitable combination of these. Additionally or alternatively, some of the blocks of the architecture 200 may be identified with hardware accelerators, as discussed in further detail herein. The architecture 200 may be implemented as part of any suitable device that is configured to wirelessly receive data transmissions in accordance with any suitable number and/or type of communication protocols. Thus, to provide some non-limiting and illustrative scenarios, the architecture 200 may be implemented as part of a base station, a user equipment (UE) such as a mobile device, a laptop, etc.

To provide various non-limiting and illustrative scenarios, the architecture 200 as further discussed herein may be implemented to facilitate communications in accordance with any suitable communication networks, protocols, standards, radio access technologies (RATs), etc., which may include any suitable type of cellular standard, such as a 3GPP standard, including new radio (NR) standards, the most recent as of this time of writing being 3GPP R16 published in June 2019, and which may comprise communication protocols that are currently and commonly referred to as "5G" protocols, long-term evolution (LTE) protocols, LTE/LTE-A, Wi-Fi 802.11 standards, etc. Additionally or alternatively, the further discussed herein may be implemented to facilitate communications comprising other communication standards such as the Open Radio Access Network (O-RAN), or those utilizing the Data Over Cable Service Interface Specification (DOCSIS), the most recent at the time of this writing being the DOCSIS 4.0 released in October of 2017.

For purposes of brevity, various components of the device in which the architecture 200 may be implemented are not shown. To provide some non-limiting and illustrative scenarios, the device may comprise one or more components that are configured to provide the demodulated data as shown in FIG. 2. These may include analog to digital converters, amplifiers, filters, demodulators, etc. In any event, the demodulated data as shown in FIG. 2 may correspond to demodulated data of a code block for which LDPC encoding has been used by a transmitting device, which is subsequently received via the device in which the architecture 200 is implemented.

The upper branch of the architecture 200, which includes the demapper 202, the LLR term block 204, the LLR scaling block 206, and the LDPC decoder block 208, may be identified with the configuration and/or operation of a typical LDPC decoder process. Such an LDPC decoder process is configured to operate in real-time on the demodulated data that is received for a particular code block. The LDPC decoder process operates by successively receiving code blocks that form a codeword, with each of the code blocks being encoded as part of the received demodulated data. The LDPC decoder block 208 attempts to decode the codeword by successfully decoding each of the code blocks, which may then be concatenated to reconstruct the code word that was used by the transmitter. For each code block, this may or may not be successful over several iterations, with success being determined at via an error checking process, i.e. a CRC or other pass/fail scheme as discussed herein.

Thus, to perform the LDPC decoding process, the architecture 200 implements a demapper 202, which functions to generate the LLR terms from the demodulated data that is identified with a particular code block. The demapper 202 may do so utilizing any suitable configuration and/or functionality, including known algorithms, hardware components, and/or techniques. The LLR terms are then provided to the LLR block 204, which may represent any suitable type or memory that is configured to store the LLR terms prior to their use, as discussed in further detail below.

The LLR terms are then scaled by applying a common scalar term to the LLR terms in accordance with known techniques. This process may be performed for each code block that is received such that the decoding process is performed at the code block decoding level. The LLR term scaling is performed in this manner via the LLR scaling block 206 via any suitable techniques, including known techniques.

Thus, the LDPC decoder 208 may comprise any suitable type of decoder that is configured to decode a received code block using the received scaled LLR terms, which are received as input data as shown in FIG. 2. The LDPC decoder 208 may be implemented in accordance with any suitable components and/or architecture, including those implemented for known LDPC decoder designs. In one non-limiting and illustrative scenario, the LDPC decoder 208 may be configured as a hardware accelerator, and thus be implemented as one or more hardware components configured to perform predetermined operations on the received scaled LLR terms. As another non-limiting and illustrative scenario, the LDPC decoder 208 may be implemented as a software component via the execution of LDPC decoder instructions, a program, etc., stored in the memory 506 of the device in which the architecture 200 is implemented. In any event, the LDPC decoder 208 may be implemented as any suitable component, which may form part of the architecture 200 or a separate component thereof, that is configured to perform code block level decoding using the LLR scaled terms. Thus, the LDPC decoder 208 and/or the architecture 200 may comprise (or form part of) an application specific integrated circuit (ASIC), a field programmable gate array (FPGA), a complex programmable logic device (CPLD), logic components, processing circuitry, etc.

Thus, it is noted that although the LLR scaling block 206 is shown in FIG. 2 as a separate component, this is for ease of explanation, and the LLR term scaling may be performed separately or as part of the operations of the LDPC decoder 208. This may include, in various illustrative and non-limiting scenarios, the hardware of the LDPC decoder 208 performing LLR term scaling based on an adjustable scalar gain or via software through scaling of the input data stream. Irrespective of the components that perform the LLR term scaling, the scaling is typically performed by selecting an LLR scaling factor to be applied to the LLR terms to generate the scaled LLR terms. The LDPC decoder 208 then operates on these scaled terms to perform the LDPC decoding as part of an iterative decoding process to attempt to successfully decode the code block (decoded output as shown in FIG. 2). A successful decoding may be confirmed by way of any suitable error checking process such as a cyclic redundancy check (CRC), a syndrome pass/fail error check, etc.

Different LDPC decoder variants implement different techniques for selecting the LLR scaling factor to attempt to minimize the number of iterations. However, conventional LDPC decoding schemes still have drawbacks. For instance, the optimum LLR scaling is often dependent upon the current channel conditions, and such conventional LDPC decoders fail to adapt to the channel conditions over time. Moreover, conventional LDPC decoders do not adapt the LLR scaling factor selection process with changes in channel conditions.

The architecture 200 addresses this issue by using existing processing resources of the device in which the architecture 200 is implemented to adapt the LLR scaling over time. The LLR scaling may be adapted in this manner based upon the particular channel heuristics that are identified with the channel used to transmit the code block. To do so, the architecture 200 implements an LDPC decoder control input model 250. The functionality of the LDPC decoder control input model 250 is primarily described herein with respect to the prediction of the scaling factors used to provide the scaled LLR terms at inference to the LDPC decoder 208 to perform real-time processing of received control blocks, as discussed above. However, the use of the LDPC decoder control input model 250 to predict LLR scaling factors is provided herein as a non-limiting and illustrative scenario, in which case the LDPC decoder control input model 250 may represent a self-adapting scaling model. However, the LDPC decoder control input model 250 may additionally or alternatively predict any suitable type of control inputs to the LDPC decoder 208, such as LLR scaling, LLR saturation, decoder offset variant, etc. This is discussed in further detail below in Section III.

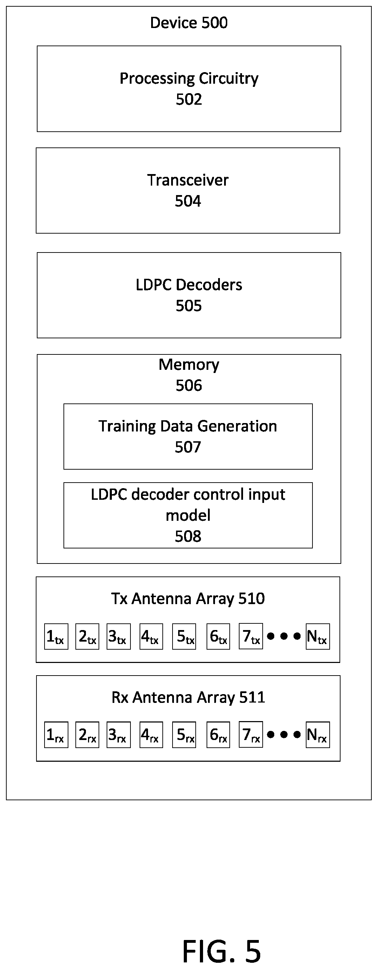

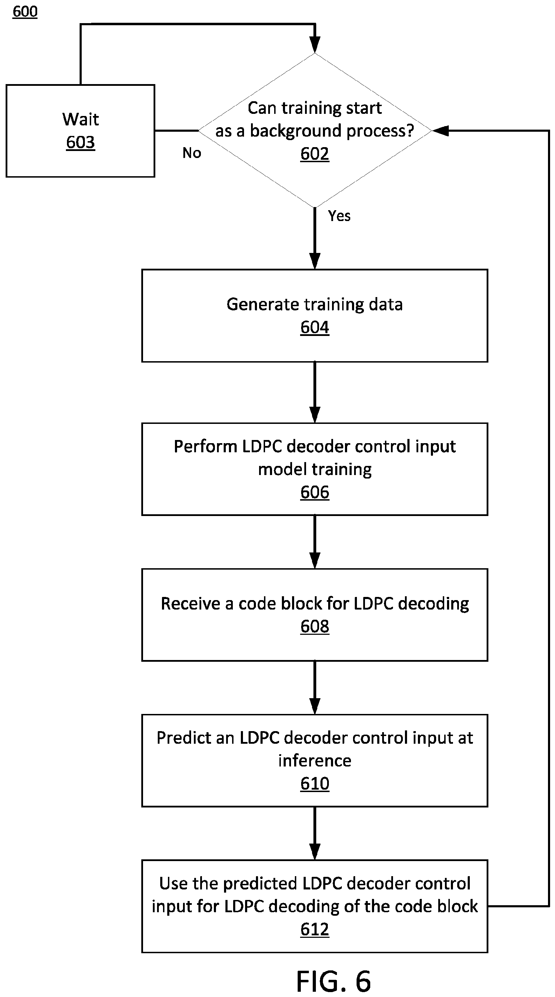

The LDPC decoder control input model 250 may be implemented as any suitable type of machine learning model that continuously adapts over time to refine the selection of one or more control inputs (such as the LLR scaling factor) that are then provided to the LDPC decoder 208 at inference. Again, the LDPC decoder inputs that are predicted in this manner via the LDPC decoder control input model 250 comprise the LLC scaling factor as a non-limiting and illustrative scenario. The LDPC decoder control input model 250 may thus be implemented, in various non-limiting and illustrative scenarios, as a machine-learning (ML) model realized as any suitable type of processors executing machine-readable instructions stored on a suitable memory. This may include the processing circuitry 502 executing instructions associated with the LDPC decoder control input model 250, which is represented with the corresponding module 508 stored in the memory 506 as shown in FIGs. 2 and 6. The processing circuitry 502 and the memory 506 may be identified with components of the device in which the architecture 200 is implemented. The processing circuitry 502 may perform, alone or in conjunction with software and/or hardware components, any of the functions discussed herein with respect to the architecture 200, as discussed in further detail herein with reference to FIG. 5.

The LDPC decoder control input model 250 thus be may be implemented as a supervised learning ML model, an unsupervised learning ML model, a semi-supervised learning ML model, a self-supervised ML model, a reinforcement learning ML model, etc. The processing circuitry 502 used to execute the ML model may also perform the various functions related to the overall training and inference functions of the LDPC decoder control input model 250. Such functions may include generating the training data, predicting the LDPC decoder control inputs at inference, evaluating various performance metrics of the training process, revising the LDPC decoder control input model 250 over time to adapt and provide better predictions, etc.

In any event, the LDPC decoder control input model 250 may be trained using a set of training data that is derived from channel heuristics measured via the channel heuristics block 210. The channel heuristics block 210 may be configured to estimate and/or measure any suitable number and/or type of channel parameters using any suitable techniques, including known techniques, which may then be correlated to the channel conditions when each code block was received. The channel heuristics block 210 may form part of the hardware and/or software of the device in which the architecture 200 is implemented, such as various receiver components capable of obtaining such information as data is received and/or by periodically performing wireless channel measurements. Such channel measurements may take place as part of the channel estimation process that is typically performed via wireless receivers. To provide various non-limiting and illustrative scenarios, the channel heuristics block 210 may measure and/or estimate channel parameters such as a multipath power delay profile, a delay spread, doppler spread, an interference level, a location of a transmitting device, a numerology, a rank, a Modulation Coding Scheme (MCS) index, etc.

The training data that is input to the LDPC decoder control input model 250, which is represented in FIG. 2 as the training block 250.1, is generated by labelling the LLR terms that are output by the demapper 202 per code block. Again, the LLR terms that are provided by the demapper 202 per code block may be stored in any suitable memory location, such as the memory 506. Thus, the previously generated LLR terms may be accessed and then labeled to generate the training data that is used to train the LDPC decoder control input model 250. This training enables the LDPC decoder control input model 250 to predict at inference the LDPC control inputs for future code blocks by referencing the channel labels, which indicate one or more channel parameters of the channel when the future code block is received. To do so, the LLR terms may be labeled, in various non-limiting and illustrative scenarios, with any combination and/or subset of the channel parameters that were measured and/or estimated via the channel heuristics block 210. In other words, the training data for the LDPC decoder control input model 250 is generated by labeling previous LLR terms based upon the respective channel parameters corresponding to when those previous LLR terms were received.

The training data may thus be continually updated over time as additional code blocks are received and additional LLR terms are stored to provide a robust and extensive data set for optimizing the predictions of the LDPC decoder control input model 250. Thus, it is noted that the LDPC decoder control input model 250 may be initially trained, such as at initial power on, during manufacturing, etc., using a default or predetermined set of labeled training data to enable the LDPC decoder control input model 250 to initially perform LDPC control input predictions. This default labeled training data may be generated using standard channel modeling techniques, knowledge regarding the operation of the device in which the architecture 200 is to be deployed, known information regarding correlations between channel conditions and specific types of LDPC decoder control inputs, etc. This default training data may then be overwritten as the architecture 200 continues to operate and collect additional *a posteriori* information, with the training process as described herein functioning to update the default training data. Alternatively, the LDPC decoder control input model 250 may be configured to output default LDPC decoder control inputs for a predetermined period of time of initial operation, until a predetermined number the code blocks have been processed, etc. For the LLR scaling factor, this may include initially outputting a default prediction of '1', which corresponds to no scaling. Then, once the LDPC decoder control input model 250 is deemed sufficiently trained, it may switch to an mode of operation during which predictions are performed at inference, as discussed in further detail herein.

It is noted that due to the highly processor-intensive computations and the speed required for receiving and decoding code blocks, the architecture 200 may comprise multiple LDPC decoders 208, each being associated with a separate component such as a hardware accelerator. In other words, the LDPC decoder 208 may be part of a set of LDPC decoders, with each LDPC decoder in the set decoding a respective code block in accordance with a respective set of scaled LLR terms. Each of the LDPC decoders within the set may operate in parallel in this manner to concurrently decode multiple code blocks as data is received.

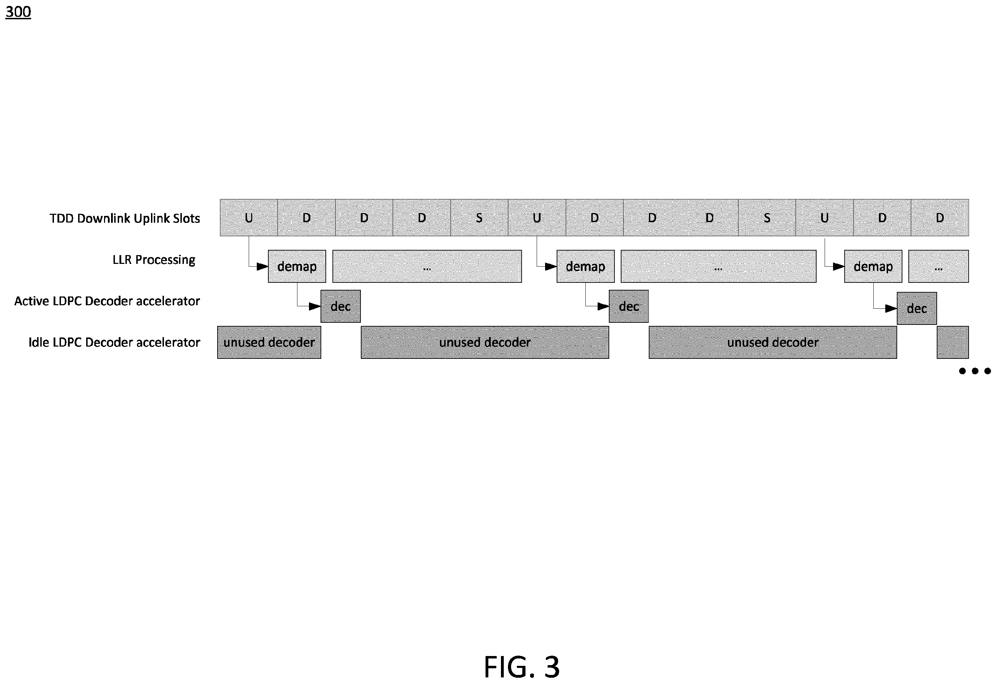

As a result, when used as part of a time-division duplexing (TDD) communication protocol, there may be time periods during which several or all of the LDPC decoders 208 in the set are inactive. These time periods may correspond to time slots during which code blocks are not expected to be decoded by the wireless device. Thus, reference is now made to FIG. 3, which illustrates a timeline associated with the decoding operations performed by an LDPC decoder, in accordance with the disclosure. As shown in FIG. 3, the TDD schedule includes uplink slots "U" during which code blocks are received, as well as downlink slots "D" during which data may be transmitted but not received. The TDD schedule also include special slots "S," during which data may be transmitted or received, but does not include receiving code blocks for decoding. Thus, because the LDPC decoders are only used during a time period associated with the uplink slots, the LDPC decoders are free and idle most of the time in architectures in which uplink communications occur less frequently than others.

Considering the significant idle time of the LDPC decoders, the time period for the training process for the LDPC decoder control input model 250, which is shown in FIG. 2 via the components in the dashed box, may advantageously be performed when one or more of the set of LDPC decoders is in an inactive or otherwise idle state. It is noted that the communication schedule for the uplink communications may also be known in advance by the device in which the architecture 200 is implemented, such as via synchronization communications that occur as part of typical wireless communications. Additionally, the time period required by the demapper 202 to generate the LLR terms, as well as a maximum time required by the LDPC decoder 208 to decode a respective code block, may also be known in advance based upon the configuration of the architecture 200. As a result, the time periods during which the LDPC decoders do not expect to receive code blocks, and thus are free to be used for the training process of the LDPC decoder control input model 250, may be anticipated in advance, with the training process occurring during such time periods as a background process.

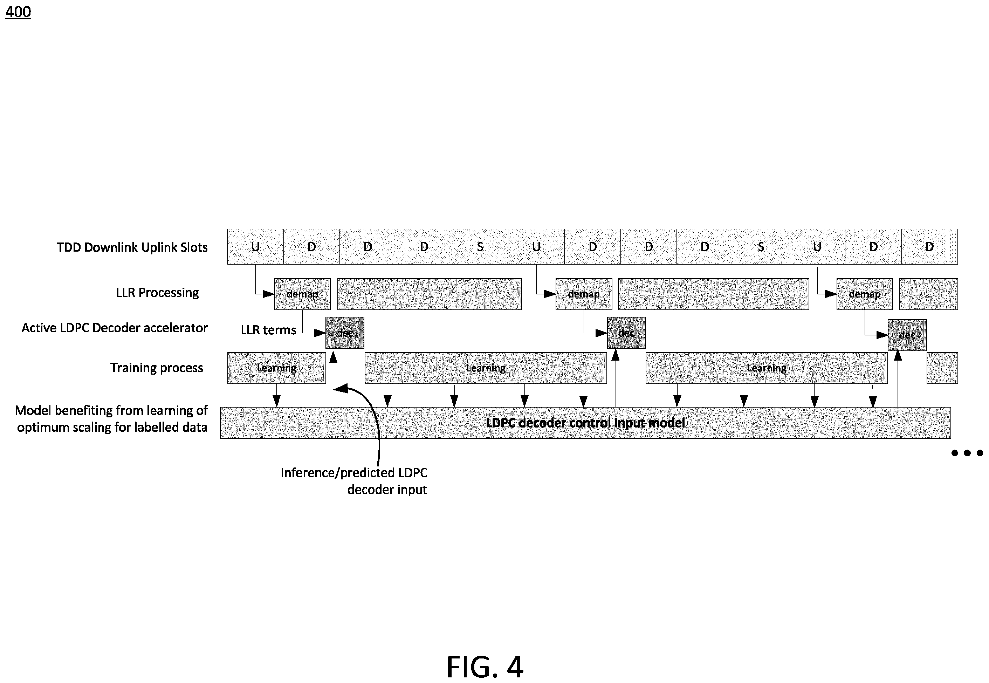

This is shown in further detail in FIG. 4, which illustrates a timeline associated with the decoding operations performed by an LDPC decoder 208 and a training process for the LDPC decoder control input model 250, in accordance with the disclosure. The use of the trained LDPC decoder control input model 250 is discussed in further detail below, although the timeline as shown in FIG. 4 illustrates that the LDPC decoder control input model 250 may be used at inference to provide the predicted scaling factor for the LPDC decoder 208 to perform the real-time decoding of a code block, as shown in FIG. 2.

Thus, the operation of the upper branch of the architecture 200 as shown in FIG. 2 includes the real-time demapping of the demodulated data to generate the LLR terms, scaling of the LLR terms, and the decoding of the code block. These processes are each performed during the uplink slots U as shown in FIG. 4, i.e. in real-time per uplink slot. The LLR scaling factor used during each uplink slot is predicted by the trained LDPC decoder control input model 250, which is then further trained during idle time slots such that future predictions are improved over time. The training process of the LDPC decoder control input model 250 may thus be executed as a background training process using free or otherwise idle LDPC decoder resources.

The time periods for the training process are shown in further detail in FIG. 4, which is discussed with respect to the non-limiting and illustrative scenario in which the LDPC control inputs comprise the LLR terms scaling factor. In this scenario, the training process is executed within the time periods as shown in an iterative manner to perform the same decoding with the labeled training data but across a range of multiple scaling values. In this way, information is gathered *a posteriori* on previously-used scaling factors for a given UE/channel characteristics. It is noted that this background processing may be exposed on a lower priority queue of the architecture 200 so as to not impact the real-time processing of the same LDPC decoder set.

Furthermore, it is also noted that the training process includes the generation of training data as noted above. That is, the generation of the training data includes labeling the LLR terms of previous code blocks with the channel parameters for those LLR terms that correspond to the channel conditions when that code block was received. The training data is then used as part of the training process, which generates multiple scaling factor candidates for a given set of labeled LLR terms. Each of these multiple scaling factor candidates is applied to the same set of labeled LLR terms to provide multiple scaled LLR candidates. The training process further includes providing each of the multiple scaled LLR candidates to the LDPC decoder 258 to decode the corresponding code block, with output metrics being used as feedback with respect to the decoding results of the LDPC decoder 258. Thus, it is noted that although the LDPC decoders 208, 258 are described herein using different reference numbers, these LDPC decoders may comprise the same LDPC decoder with the LDPC decoder set or different LDPC decoders, depending upon which LDPC decoders are idle when the training process is performed.

In any event, the LDPC decoders 208, 258 may operate in an identical manner such that the training process mirrors the real-time processing of the LDPC decoder 208 using alternate scaling factors. To do so, the training process includes a comparison of output metrics resulting from the LDPC decoding (via the LDPC decoder 258) of the same labeled set of LLR terms using different scaling factors, with each decoding process being executed in a sequential manner by the LDPC decoder 258. By way of this comparison, the training process aims to optimize the scaling factors for a particular set of LLR terms and channel parameters by retaining the scaling factor for the previously-used LLR terms that results in the best output metrics. By continuously performing this training process in the background over time, the LDPC decoder control input model 250 is refined to predict at inference an optimized (or at least improved) scaling factor for each code block that is received based upon the channel parameters and LLR terms.

This allows the LDPC decoder control input model 250 to benefit from machine learning scaling to gather data continuously on the LLR terms being processed based on the different scaling values. In this way, the training process includes LLR term scaling in the background on the same data without any significant cost in terms of software processing, capacity, or impact to the real-time processing requirements. This enables information to be gathered regarding what would have been the best LLR scaling choice for a given channel condition (based upon the channel parameter labels), and for this scheme to be refined continuously in the background.

In this way, the LDPC decoder control input model 250 is trained to predict LDPC decoder control inputs using the training data, which again is generated based upon the labeled previous log likelihood ratio (LLR) terms used by the LDPC decoder 208. Again, the LDPC decoder control input model 250 is trained to predict the LDPC decoder control inputs using the performance measurement results (i.e. the output metrics) of the LDPC decoder 258 using the previous LLR terms that were scaled and provided as input to the LDPC decoder 208 during a previous code block transmission.

Once trained in this manner, the trained LDPC decoder control input model 250 is then used to compute, at inference, a control input for the LDPC decoder 208 for LLR terms associated with a currently-received code block, i.e. a code block received in real-time and subsequent to the code block used to perform the training process described herein. The trained LDPC decoder control input model 250 may perform this prediction at inference using channel condition labels that have been generated and are associated with the channel heuristics, which again may be identified with various channel parameters that are measured and/or estimated by the channel heuristics block 210 with respect to the current channel conditions.

The labels associated with the current channel conditions may be used by the trained LDPC decoder control input model 250 to predict the control input for the LDPC decoder 208 for LLR terms. This may include the use of any suitable correlation and/or matching process that predicts a control input for the LDPC decoder 208 for current channel conditions from previous control inputs that are identified with similar, past channel conditions. This process may be performed using any suitable techniques, including those known to be implemented as part of the operation of trained ML models for performing predictions at inference using a labeled training data set.

The channel conditions for the currently-received code block may differ from the channel conditions when the previous LLR terms were received, which were used to train the LDPC decoder control input model 250 as noted above. Thus, trained LDPC decoder control input model 250 is configured to predict, at inference, an LDPC decoder control input based upon the measured and/or estimated channel parameters corresponding to when the current code block was received. The LDPC decoder 208 then decodes the (current, i.e. in real-time as received) code block using the predicted LDPC decoder control input.

Thus, and as shown in FIG. 2, the predicted LDPC decoder control input comprises the LLR terms scaling factor, although this is again a non-limiting and illustrative scenario. Using the scaling factor as an illustrative scenario, the trained LDPC decoder control input model 250 comprises an LLR scaling model. The LLR scaling model, once trained as noted above, is configured to predict (as the predicted LDPC decoder control input in this scenario), a predicted LLR scaling factor at inference for the code block that is received subsequent to the previous LLR terms that were received and used for the training process described above. The LLR terms are then scaled using this predicted scaling factor, as shown in the LLR scaling block 206 of FIG. 2. The LDPC decoder 208 is configured to decode the currently received code block (in real-time) using the set of scaled LLR terms as input data, which have been generated using the predicted LLR scaling factor provided by the LDPC decoder control input model 250 as discussed herein.

Again, the training process used for the trained LDPC decoder control input model 250 includes testing several LDPC decoder control inputs. The optimum LDPC decoder control inputs are then determined for a specific set of labels and LLR terms based upon the performance measurement results of the LDPC decoder 258 for each control input that is tested in this manner. Thus, and using the LLR scaling factor as the LDPC control input as an illustrative and non-limiting scenario, each set of LLR terms that were previously received per respective code block and channel conditions is tested as part of the training process by selecting and applying several scaling factors to a single set of LLR terms and observing the performance measurement results.

The number of LLR scaling factors, their specific values, and/or the granularity of the LLR scaling factors may be selected in this manner for training in accordance with any suitable manner. This may include the use of a predetermined set of rules, a scaling factor selection that is based upon known, default, or predetermined scaling factors for various channel conditions, a scaling factor selection that is based upon a predetermined variance of the previously-used (i.e. that used by the LDPC decoder 208 for the same LLR terms), a predetermined variance of a predetermined scaling factor, etc. To provide some non-limiting and illustrative scenarios, the scaling factor may have a value in a range around 1.0, such as between 0.7 to 2.0. Thus, for each one of the previously received LLR terms, the training process includes iteratively applying a different scaling factor for decoding the same code block to generate a corresponding set of scaled LLR terms. Then, for each iteration (i.e. each different scaling factor), performance measurement results of the LDPC decoder 258 are determined when decoding the same code block using each different set of scaled LLR terms.

That is, the selection of the scaling factor impacts the performance of the LDPC decoder 258 for decoding the corresponding code block, and thus this process may yield an optimum scaling factor that results in maximum performance results of the LDPC decoder 258 in doing so. The
performance measurement results used to drive the training process for optimizing the scaling factor for specific channel conditions may include any suitable performance metrics that are indicative of optimizing the probability of successfully decoding the control block and/or a reduction in (such as the minimization of) the Block Error Rate (BLER). In this way, the training process results in the trained LDPC decoder control input model 250 predicting, for the current channel conditions as each code block is received in real-time, an LDPC decoder control input that results in the LDPC decoder 208 maximizing (or at least increasing) a probability of successful decoding the corresponding code block. Again, for the current scenario, this LDPC control input may comprise an LLR term scaling factor. In accordance with such a scenario, the trained LDPC decoder control input model 250 predicts, for the current channel conditions as each code block is received in real-time, an LLR term scaling factor that is used to provide a respective set of scaled LLR terms, which results in the LDPC decoder 208 maximizing (or at least increasing) a probability of successful decoding the corresponding code block.

Thus, it is noted that the LDPC decoding process itself is typically performed over multiple iterations using the same scaling factor for the LLR terms. The number of iterations required to successfully decode a code block for a particular LLR scaling factor and set of LLR terms is thus indicative of the probability of a successful decoding of the control block. Therefore, the number of iterations required by the LDPC decoder 258 to successfully decode the code block for each different scaling factor may be used as a performance metric that is indicative of the optimization of the scaling factor for specific channel conditions. That is, the performance measurement results of the LDPC decoder 258 may comprise a number of LDPC decoder iterations needed to compute, using a respective set of scaled LLR terms, a corresponding code block that successfully passes an error checking process. The error checking process may include any suitable type of process that verifies that the coded block has been successfully decoded by the LDPC decoder 258. To provide some illustrative and non-limiting scenarios, this may include a cyclic redundancy check (CRC) or a syndrome pass/fail error check.

Advantageously, the LDPC decoder control input model 250 may benefit from continuous learning of an optimum scaling to adapt to the best scheme for a given deployment location and channel condition. In parallel with the training process, the LDPC decoder control input model 250 also provides the predicted optimum scaling factors for real-time processing based on previous learning. For instance, and turning back to FIG. 4, it is noted that the LLR terms that have been processing for a particular U slot are then processed with different scaling factors iteratively afterwards as part of a background learning process. The processing that is then performed during the next U slot is for new LLR data and new labels, but still benefits from the previous learning as noted above.

### III. Variant for LLR saturation level

Again, the LDPC decoder control input model 250 may be trained to predict at inference any suitable control input for the LDPC decoder 208. The LLR scaling factor is described above as one illustrative and non-limiting scenario of the predicted LDPC decoder control input. However, as another non-limiting and illustrative scenario, the LDPC decoder control input model 250 may be trained to alternatively or additional predict at inference the LLR saturation level using the same architecture 200 as described herein. Thus, the architecture 200 may enable the LDPC decoder control input model 250 to provide an optimum LLR scaling as well as an optimum LLR saturation level. Generally, and to provide one non-limiting and illustrative scenario, the LLR saturation level is adjusted by truncating the MSB of the LLR saturation level by a specific number of bits as part of the LDPC decoder processing. Other non-limiting and illustrative scenarios may include using other forms of the LLR saturation level or adjusting the LLR saturation with a lower granularity x = max(-s, min(xms)).

For instance, for some channel conditions, receivers are known to possibly provide a large LLR magnitude with the wrong hard decision, which can become extremely counterproductive for the LDPC decoders. In such scenarios, it may be advantageous to reduce the range of the LLR terms regardless of the actual value provided by the receiver. The same LDPC decoder control input model 250 could thus be implemented to predict which condition (from labeled LLR terms using the channel conditions as described herein) may result in the LLR saturation being tuned, in addition to the LLR scaling, to achieve an optimal LLR representation for a channel and receiver chain, thereby avoiding this drawback. Conventionally, the LLR saturation is coarsely controlled, but without a suitable tuning scheme to optimize this control input.

### IV. A wireless device implementing a self-adaptive and learning architecture

FIG. 5 illustrates a device, in accordance with the present disclosure. The device 500 may be implemented as a standalone device or a component that is used for any suitable type of wireless communication application. Thus, the device 500 may alternatively be referred to as a communication device or a wireless device. To provide various non-limiting and illustrative scenarios, the device 500 may be implemented as part of or comprise a base station or a UE as discussed above with respect to FIG. 2, or as any other suitable device that wirelessly receives data, such as transmitted code bocks, from other devices. The device 500 may include one or more components configured to transmit and/or receive wireless signals. The device 500 may perform any of the functions as discussed herein with respect to the generation of training data, training the LDPC decoder control input model 250, performing predictions of LDPC control inputs at inference via the LDPC decoder control input model 250, etc.

To do so, the device 500 may include processing circuitry 502, a transceiver 504, one or more LDPC decoders 505, a memory 506, a transmit antenna array 510 including any suitable number *Ntx* of transmit antennas, and a receive antenna array 511 including any suitable number *Nrx* of receive antennas. The components shown in FIG. 5 are provided for ease of explanation, and the device 500 may implement additional, less, or alternative components as those shown in FIG. 5. Thus, in various non-limiting and illustrative scenarios, the computing device 500 may include one or more power sources, display interfaces, peripheral devices, ports, etc. Further, although the transmit and receive antenna arrays 510, 511 are illustrated in FIG. 5 as separate arrays, these may be combined into a single antenna array that may be controlled by the device 500 to receive and/or transmit signals at different times.

The processing circuitry 502 may be configured as any suitable number and/or type of computer processors, processing circuitry, hardware circuitry, etc., which may function to control the computing device 500 and/or other components of the computing device 500. The processing circuitry 502 may be identified with one or more processors (or suitable portions thereof) implemented by the device 500. The processing circuitry 502 may be identified with one or more processors such as a central processing unit (CPU), a host processor, a digital signal processor, one or more microprocessors, graphics processors, baseband processors, microcontrollers, an application-specific integrated circuit (ASIC), part (or the entirety of) a field-programmable gate array (FPGA), etc.

In any event, the processing circuitry 502 may be configured to carry out instructions to perform arithmetical, logical, and/or input/output (I/O) operations, and/or to control the operation of one or more components of device 500 to perform various functions as described herein. The processing circuitry 502 may include one or more microprocessor cores, memory registers, buffers, clocks, etc., and may generate electronic control signals associated with the components of the device 500 to control and/or modify the operation of these components. The processing circuitry 502 may communicate with and/or control functions associated with the transceiver 504, the LDPC decoders 505, the memory 506, the transmit antennas 510, and/or the receive antennas 511.

The transceiver 504 may be implemented as any suitable number and/or type of components configured to transmit and/or receive data (such as code blocks) and/or wireless signals in accordance with any suitable number and/or type of communication protocols. The transceiver 504 may include any suitable type of components to facilitate this functionality, including components associated with known transceiver, transmitter, and/or receiver operation, configurations, and implementations. Although depicted in FIG. 5 as a single transceiver, the transceiver 504 may represent any suitable number of transceivers, transmitters, receivers, or combinations of these that may be integrated into a single transceiver or as multiple transceivers or transceiver modules. The transceiver 504 may include components typically identified with an RF front end and include antennas, ports, power amplifiers (PAs), RF filters, mixers, local oscillators (LOs), low noise amplifiers (LNAs), upconverters, downconverters, channel tuners, etc.

Thus, the transceiver 504 may be configured as any suitable number and/or type of components configured to facilitate receiving and/or transmitting data and/or signals in accordance with one or more communication protocols. The transceiver 504 may be implemented as any suitable number and/or type of components to support wireless communications such as analog-to-digital converters (ADCs), digital to analog converters, intermediate frequency (IF) amplifiers and/or filters, modulators, demodulators, baseband processors, etc. The data received via the transceiver 504, data provided to the transceiver 504 for transmission, and/or data used in conjunction with the transmission and/or reception of data via the transceiver 504 (such as beamforming weights) may be processed via the processing circuitry 502 and the LDPC decoders 505, as discussed herein.

The LDPC decoders 505 may be identified with any suitable number and/or type of LDPC decoders that attempt to decode code blocks from received LDPC decoder control inputs, as discussed herein. The LDPC decoders 505 may be identified with a set of LDPC decoders implemented by the device 500 that includes the LDPC decoders 208, 258, as discussed herein.

The memory 506 is configured to store data and/or instructions such that, when the instructions are executed by the processing circuitry 502, cause the device 500 to perform any of the various functions as described herein. The memory 506 may be implemented as any suitable volatile and/or non-volatile memory, including read-only memory (ROM), random access memory (RAM), flash memory, a magnetic storage media, an optical disc, erasable programmable read only memory (EPROM), programmable read only memory (PROM), etc. The memory 506 may be non-removable, removable, or a combination of both. The memory 506 may be implemented as a non-transitory computer readable medium storing one or more executable instructions such as, for example, logic, algorithms, code, etc.

As further discussed below, the instructions, logic, code, etc., stored in the memory 506 are represented by the various modules as shown, which may enable the functionality disclosed herein to be functionally realized. Alternatively, the modules as shown in FIG. 5 that are associated with the memory 506 may include instructions and/or code to facilitate control and/or monitor the operation of hardware components implemented via the computing device 500. In other words, the modules shown in FIG. 5 are provided for ease of explanation regarding the functional association between hardware and software components. Thus, the processing circuitry 502 may execute the instructions stored in these respective modules in conjunction with one or more hardware components to perform any of the various functions as discussed herein. Although illustrated as separate modules, this is for ease of explanation, and it will be understood that the memory 506 may store computer-readable instructions in any suitable format as an executable set of data instructions such that any of the functionality as described herein may be performed via execution of the instructions stored in the memory 506.

The executable instructions stored in the training data generation module 507 may facilitate, in conjunction with execution via the processing circuitry 502, the device 500 generating any of the training data as discussed herein, which may then be used to perform training of the LDPC decoder control input model 250 as discussed herein. This may include the generation of labeled training data, such as labeling the LLR terms with labels corresponding to the various channel parameters as discussed above with respect to the architecture 200. Thus, the training data generation module 507 may facilitate, in conjunction with execution of instructions via the processing circuitry 502, the device 500 realizing the entirety or a portion of the functionality of the architecture 200.

The LDPC decoder control input model 508 may represent the executable instructions identified with the functional realization and operation of the LDPC decoder control input model 250 as shown and discussed above with respect to FIG. 2. Thus, the LDPC decoder control input model 508 may facilitate, in conjunction with execution of instructions via the processing circuitry 502, the device 500 realizing an entirety or a portion of the architecture of any suitable type of machine learning model.

### V. A process flow

FIG. 6 illustrates a process flow, in accordance with the present disclosure. With reference to FIG. 6, the flow 600 may be a computer-implemented method executed by and/or otherwise associated with one or more processors (processing circuitry), other hardware components, and/or storage devices. These processors, other hardware components, and/or storage devices may be associated with one or more computing components identified with any suitable device (such as the device 500, a device in which the architecture 200 is implemented, etc.). The one or more processors may execute instructions stored on any suitable computer-readable storage medium, which may or may not be shown in the Figures. The flow 600 may include alternate or additional steps that are not shown in FIG. 6 for purposes of brevity, and may be performed in a different order than the steps shown in FIG. 6.

Flow 600 may begin by determining (block 602) whether training can start as a background process. This may include, in a non-limiting and illustrative scenario, a determination regarding whether one or more LDPC decoders are inactive. This may include, as discussed herein, the determination of a time period in accordance with a TDD schedule during which data may be transmitted but not received, or when code blocks for decoding are otherwise not expected to be received. Additionally or alternatively, the determination (block 602) may be based upon any other suitable factors, such as a priority queue that establishes a higher priority for processing that is to be performed in real-time and a lower priority for background or other non-real-time processing tasks. Thus, the determination (block 602) may be performed such that the training process does not interfere or otherwise impact higher priority processing, which may include LDPC decoding in real-time or any other suitable processing that is deemed a higher priority. If not, the flow 600 may proceed to wait (block 603) until such a time period during which one or more LDPC decoders are inactive and/or the training process may otherwise be performed.

Once it is determined (block 602, yes) that the background training process may begin, the flow 600 may proceed to generate (block 604) the training data. Again, this may include generating the training data by labeling the LLR terms from previous code block processing with one or more channel parameter labels identified with the channel conditions when the LLR terms were received. This may comprise accessing the LLR terms from a stored memory location for this purpose, as discussed above with respect to the architecture 200. This may include appending and/or overwriting previous training data as additional code blocks are received and decoded.

Flow 600 may include performing (block 606) LDPC decoder control input model training. This training process may be the one described above with respect to the architecture 200. For instance, the training process may include training the LDPC decoder control input model 250 using the training data to iteratively test multiple control input values and measuring the performance metrics of the LDPC decoder for each iteration. This training process aims to optimize the LDPC decoder control input model predictions for a particular set of channel conditions and LLR terms.

Flow 600 may include receiving (block 608) a subsequent code block after receiving the code block used to generate (block 604) the training data. This may include receiving an uplink transmission during an uplink slot, as discussed above with respect to the architecture 200.

Flow 600 may include predicting (block 610) a LDPC decoder control input during inference. This may include the generation of a predicted LDPC decoder control input such as a scaling factor, which is then used by an LDPC decoder in real-time to perform LDPC decoding of the subsequently-received code block.

Flow 600 may include using (block 712) the predicted (block 610) LDPC decoder control input for LDPC decoding of the subsequently-received code block. This may include the LDPC decoder 208 performing LDPC decoding using the LLR terms and the predicted (block 610) LDPC decoder control input to decode the code block. Again, this LDPC decoder control input may comprise an LLR scaling factor such that the LDPC decoder 208 performs the LDPC decoding using the LLR terms that have been scaled in accordance with the predicted scaling factor output by the trained LDPC decoder control input model 250, as discussed above with respect to the architecture 200.

### VI. General operation of a first wireless device

A first wireless device is provided. The first wireless device comprises a low-density parity check (LDPC) decoder; and a processor configured to execute instructions stored in a memory to: train an LDPC decoder control input model to predict LDPC decoder control inputs using (i) training data that is based upon previous log likelihood ratio (LLR) terms used by the LDPC decoder, and (ii) performance measurement results of the LDPC decoder using the previous LLR terms; and compute, via the trained LDPC decoder control input model at inference for a code block that is received subsequent to the previous LLR terms, a predicted LDPC decoder control input based upon estimated channel parameters corresponding to when the code block was received. The LDPC decoder is configured to decode the code block using the predicted LDPC decoder control input, and the processor is configured to train the LDPC decoder control input model during inactive decoding periods of the LDPC decoder. In addition or in alternative to and in any combination with the optional features previously explained in this paragraph, the trained LDPC decoder control input model comprises a LLR scaling model that is configured to predict, as the predicted LDPC decoder control input, a predicted LLR scaling factor at inference for the code block that is received subsequent to the previous LLR terms, and the LDPC decoder is configured to decode the code block using a set of scaled LLR terms that are generated using the predicted LLR scaling factor. In addition or in alternative to and in any combination with the optional features previously explained in this paragraph, the processor is configured to generate the training data by labelling the previous LLR terms. In addition or in alternative to and in any combination with the optional features previously explained in this paragraph, the labelling of the previous LLR terms is based upon respective channel parameters corresponding to when the previous LLR terms were received. In addition or in alternative to and in any combination with the optional features previously explained in this paragraph, the channel parameters comprise one or more of a multipath power delay profile, delay spread, doppler spread, an interference level, a location of a transmitting device, a numerology, a rank, or a Modulation Coding Scheme (MCS) index. In addition or in alternative to and in any combination with the optional features previously explained in this paragraph, the processor is configured to train the LDPC decoder control input model by: for each one of the previous LLR terms, iteratively applying a different scaling factor for decoding a respective code block to thereby generate a respective set of scaled LLR terms; and for each iteration, determining performance measurement results of the LDPC decoder when decoding the respective code block using each respective set of the scaled LLR terms. In addition or in alternative to and in any combination with the optional features previously explained in this paragraph, the performance measurement results of the LDPC decoder comprise a number of LDPC decoder iterations needed to compute, using a respective set of scaled LLR terms, a corresponding code block that successfully passes an error checking process. In addition or in alternative to and in any combination with the optional features previously explained in this paragraph, the predicted LDPC decoder control input comprises a predicted LLR scaling factor used to provide a respective set of scaled LLR terms that results in the LDPC decoder maximizing a probability of successful decoding of a corresponding code block. In addition or in alternative to and in any combination with the optional features previously explained in this paragraph, the error checking process includes a cyclic redundancy check (CRC) or a syndrome pass/fail error check.

### VII. General operation of a non-transitory computer-readable medium

A non-transitory computer-readable medium is provided. The non-transitory computer-readable medium has instructions stored thereon that, when executed by a processor of a wireless device, cause the wireless device to: train an LDPC decoder control input model to predict LDPC decoder control inputs using (i) training data that is based upon previous log likelihood ratio (LLR) terms used by a LDPC decoder, and (ii) performance measurement results of the LDPC decoder using the previous LLR terms; and compute, via the trained LDPC decoder control input model at inference for a code block that is received subsequent to the previous LLR terms, a predicted LDPC decoder control input based upon estimated channel parameters corresponding to when the code block was received. The LDPC decoder is configured to decode the code block using the predicted LDPC decoder control input, and the processor is configured to train the LDPC decoder control input model during inactive decoding periods of the LDPC decoder. In addition or in alternative to and in any combination with the optional features previously explained in this paragraph, the trained LDPC decoder control input model comprises a LLR scaling model that is configured to predict, as the predicted LDPC decoder control input, a predicted LLR scaling factor at inference for the code block that is received subsequent to the previous LLR terms, and the LDPC decoder is configured to decode the code block using a set of scaled LLR terms that are generated using the predicted LLR scaling factor. In addition or in alternative to and in any combination with the optional features previously explained in this paragraph, the instructions, when executed by the processor, cause the wireless device to generate the training data by labelling the previous LLR terms. In addition or in alternative to and in any combination with the optional features previously explained in this paragraph, the labelling of the previous LLR terms is based upon respective channel parameters corresponding to when the previous LLR terms were received. In addition or in alternative to and in any combination with the optional features previously explained in this paragraph, the channel parameters comprise one or more of a multipath power delay profile, delay spread, doppler spread, an interference level, a location of a transmitting device, a numerology, a rank, or a Modulation Coding Scheme (MCS) index. In addition or in alternative to and in any combination with the optional features previously explained in this paragraph, the instructions, when executed by the processor, cause the wireless device to train the LDPC decoder control input model by: for each one of the previous LLR terms, iteratively applying a different scaling factor for decoding a respective code block to thereby generate a respective set of scaled LLR terms; and for each iteration, determining performance measurement results of the LDPC decoder when decoding the respective code block using a respective set of the scaled LLR terms. In addition or in alternative to and in any combination with the optional features previously explained in this paragraph, the performance measurement results of the LDPC decoder comprise a number of LDPC decoder iterations needed to compute, using a respective set of scaled LLR terms, a corresponding code block that successfully passes an error checking process. In addition or in alternative to and in any combination with the optional features previously explained in this paragraph, the predicted LDPC decoder control input comprises a predicted LLR scaling factor used to provide a respective set of scaled LLR terms that results in the LDPC decoder maximizing a probability of successful decoding of a corresponding code block. In addition or in alternative to and in any combination with the optional features previously explained in this paragraph, the error checking process includes a cyclic redundancy check (CRC) or a syndrome pass/fail error check.

### VIII. General operation of a second wireless device

A second wireless device is provided. The second wireless device comprises a low-density parity check (LDPC) decoder; and a processor configured to execute instructions stored in a memory to: train a log likelihood ratio (LLR) scaling model to predict LLR scaling factors using (i) training data that is based upon previous LLR terms used by the LDPC decoder, and (ii) performance measurement results of the LDPC decoder using the previous LLR terms; and compute, via the trained LLR scaling model at inference for a code block that is received subsequent to the previous LLR terms, a predicted LLR scaling factor based upon estimated channel parameters corresponding to when the code block was received. The LDPC decoder is configured to decode the code block using a set of scaled LLR terms that are generated using the predicted LLR scaling factor. In addition or in alternative to and in any combination with the optional features previously explained in this paragraph, the processor is configured to train the LLR scaling model by: for each one of the previous LLR terms, iteratively applying a scaling factor for decoding a respective code block to thereby generate a set of scaled LLR terms; and for each iteration, determining performance measurement results of the LDPC decoder when decoding the respective code block using a respective set of scaled LLR terms.

### Examples

The following examples pertain to various techniques of the present disclosure.

An example (e.g. example 1) is directed to wireless device, comprising: a low-density parity check (LDPC) decoder; and a processor configured to execute instructions stored in a memory to: train an LDPC decoder control input model to predict LDPC decoder control inputs using (i) training data that is based upon previous log likelihood ratio (LLR) terms used by the LDPC decoder, and (ii) performance measurement results of the LDPC decoder using the previous LLR terms; and compute, via the trained LDPC decoder control input model at inference for a code block that is received subsequent to the previous LLR terms, a predicted LDPC decoder control input based upon estimated channel parameters corresponding to when the code block was received, wherein the LDPC decoder is configured to decode the code block using the predicted LDPC decoder control input, and wherein the processor is configured to train the LDPC decoder control input model during inactive decoding periods of the LDPC decoder.

Another example (e.g. example 2), relates to a previously-described example (e.g. example 1), wherein the trained LDPC decoder control input model comprises a LLR scaling model that is configured to predict, as the predicted LDPC decoder control input, a predicted LLR scaling factor at inference for the code block that is received subsequent to the previous LLR terms, and wherein the LDPC decoder is configured to decode the code block using a set of scaled LLR terms that are generated using the predicted LLR scaling factor.

Another example (e.g. example 3) relates to a previously-described example (e.g. one or more of examples 1-2), wherein the processor is configured to generate the training data by labelling the previous LLR terms.

Another example (e.g. example 4) relates to a previously-described example (e.g. one or more of examples 1-3), wherein the labelling of the previous LLR terms is based upon respective channel parameters corresponding to when the previous LLR terms were received.

Another example (e.g. example 5) relates to a previously-described example (e.g. one or more of examples 1-4), wherein the channel parameters comprise one or more of a multipath power delay profile, delay spread, doppler spread, an interference level, a location of a transmitting device, a numerology, a rank, or a Modulation Coding Scheme (MCS) index.

Another example (e.g. example 6) relates to a previously-described example (e.g. one or more of examples 1-5), wherein the processor is configured to train the LDPC decoder control input model by: for each one of the previous LLR terms, iteratively applying a different scaling factor for decoding a respective code block to thereby generate a respective set of scaled LLR terms; and for each iteration, determining performance measurement results of the LDPC decoder when decoding the respective code block using each respective set of the scaled LLR terms.

Another example (e.g. example 7) relates to a previously-described example (e.g. one or more of examples 1-6), wherein the performance measurement results of the LDPC decoder comprise a number of LDPC decoder iterations needed to compute, using a respective set of scaled LLR terms, a corresponding code block that successfully passes an error checking process.

Another example (e.g. example 8) relates to a previously-described example (e.g. one or more of examples 1-7), wherein the predicted LDPC decoder control input comprises a predicted LLR scaling factor used to provide a respective set of scaled LLR terms that results in the LDPC decoder maximizing a probability of successful decoding of a corresponding code block.

Another example (e.g. example 9) relates to a previously-described example (e.g. one or more of examples 1-8), wherein the error checking process includes a cyclic redundancy check (CRC) or a syndrome pass/fail error check.

An example (e.g. example 10) is directed to a non-transitory computer-readable medium having instructions stored thereon that, when executed by a processor of a wireless device, cause the wireless device to: train an LDPC decoder control input model to predict LDPC decoder control inputs using (i) training data that is based upon previous log likelihood ratio (LLR) terms used by a LDPC decoder, and (ii) performance measurement results of the LDPC decoder using the previous LLR terms; and compute, via the trained LDPC decoder control input model at inference for a code block that is received subsequent to the previous LLR terms, a predicted LDPC decoder control input based upon estimated channel parameters corresponding to when the code block was received, wherein the LDPC decoder is configured to decode the code block using the predicted LDPC decoder control input, and wherein the processor is configured to train the LDPC decoder control input model during inactive decoding periods of the LDPC decoder.

Another example (e.g. example 11), relates to a previously-described example (e.g. example 10), wherein the trained LDPC decoder control input model comprises a LLR scaling model that is configured to predict, as the predicted LDPC decoder control input, a predicted LLR scaling factor at inference for the code block that is received subsequent to the previous LLR terms, and wherein the LDPC decoder is configured to decode the code block using a set of scaled LLR terms that are generated using the predicted LLR scaling factor.

Another example (e.g. example 12) relates to a previously-described example (e.g. one or more of examples 10-11), wherein the instructions, when executed by the processor, cause the wireless device to generate the training data by labelling the previous LLR terms.

Another example (e.g. example 13) relates to a previously-described example (e.g. one or more of examples 10-12), wherein the labelling of the previous LLR terms is based upon respective channel parameters corresponding to when the previous LLR terms were received.

Another example (e.g. example 14) relates to a previously-described example (e.g. one or more of examples 10-13), wherein the channel parameters comprise one or more of a multipath power delay profile, delay spread, doppler spread, an interference level, a location of a transmitting device, a numerology, a rank, or a Modulation Coding Scheme (MCS) index.

Another example (e.g. example 15) relates to a previously-described example (e.g. one or more of examples 10-14), wherein the instructions, when executed by the processor, cause the wireless device to train the LDPC decoder control input model by: for each one of the previous LLR terms, iteratively applying a different scaling factor for decoding a respective code block to thereby generate a respective set of scaled LLR terms; and for each iteration, determining performance measurement results of the LDPC decoder when decoding the respective code block using a respective set of the scaled LLR terms.

Another example (e.g. example 16) relates to a previously-described example (e.g. one or more of examples 10-15), wherein the performance measurement results of the LDPC decoder comprise a number of LDPC decoder iterations needed to compute, using a respective set of scaled LLR terms, a corresponding code block that successfully passes an error checking process.

Another example (e.g. example 17) relates to a previously-described example (e.g. one or more of examples 10-16), wherein the predicted LDPC decoder control input comprises a predicted LLR scaling factor used to provide a respective set of scaled LLR terms that results in the LDPC decoder maximizing a probability of successful decoding of a corresponding code block.

Another example (e.g. example 18) relates to a previously-described example (e.g. one or more of examples 10-17), wherein the error checking process includes a cyclic redundancy check (CRC) or a syndrome pass/fail error check.

An example (e.g. example 19) is directed to wireless device, comprising: a low-density parity check (LDPC) decoder; and a processor configured to execute instructions stored in a memory to: train a log likelihood ratio (LLR) scaling model to predict LLR scaling factors using (i) training data that is based upon previous LLR terms used by the LDPC decoder, and (ii) performance measurement results of the LDPC decoder using the previous LLR terms; and compute, via the trained LLR scaling model at inference for a code block that is received subsequent to the previous LLR terms, a predicted LLR scaling factor based upon estimated channel parameters corresponding to when the code block was received, wherein the LDPC decoder is configured to decode the code block using a set of scaled LLR terms that are generated using the predicted LLR scaling factor.

Another example (e.g. example 20), relates to a previously-described example (e.g. example 19), wherein the processor is configured to train the LLR scaling model by: for each one of the previous LLR terms, iteratively applying a scaling factor for decoding a respective code block to thereby generate a set of scaled LLR terms; and for each iteration, determining performance measurement results of the LDPC decoder when decoding the respective code block using a respective set of scaled LLR terms.

An example (e.g. example 21) is directed to wireless device, comprising: a low-density parity check (LDPC) decoding means; and a processing means for executing instructions stored in a memory to: train an LDPC decoder control input model to predict LDPC decoder control inputs using (i) training data that is based upon previous log likelihood ratio (LLR) terms used by the LDPC decoding means, and (ii) performance measurement results of the LDPC decoding means using the previous LLR terms; and compute, via the trained LDPC decoder control input model at inference for a code block that is received subsequent to the previous LLR terms, a predicted LDPC decoder control input based upon estimated channel parameters corresponding to when the code block was received, wherein the LDPC decoding means decodes the code block using the predicted LDPC decoder control input, and wherein the processing means train the LDPC decoder control input model during inactive decoding periods of the LDPC decoding means.

Another example (e.g. example 22), relates to a previously-described example (e.g. example 21), wherein the trained LDPC decoder control input model comprises a LLR scaling model that is configured to predict, as the predicted LDPC decoder control input, a predicted LLR scaling factor at inference for the code block that is received subsequent to the previous LLR terms, and wherein the LDPC decoding means decodes the code block using a set of scaled LLR terms that are generated using the predicted LLR scaling factor.

Another example (e.g. example 23) relates to a previously-described example (e.g. one or more of examples 21-22), wherein the processing means generates the training data by labelling the previous LLR terms.

Another example (e.g. example 24) relates to a previously-described example (e.g. one or more of examples 21-23), wherein the labelling of the previous LLR terms is based upon respective channel parameters corresponding to when the previous LLR terms were received.

Another example (e.g. example 25) relates to a previously-described example (e.g. one or more of examples 21-24), wherein the channel parameters comprise one or more of a multipath power delay profile, delay spread, doppler spread, an interference level, a location of a transmitting device, a numerology, a rank, or a Modulation Coding Scheme (MCS) index.

Another example (e.g. example 26) relates to a previously-described example (e.g. one or more of examples 21-25), wherein the processing means trains the LDPC decoder control input model by: for each one of the previous LLR terms, iteratively applying a different scaling factor for decoding a respective code block to thereby generate a respective set of scaled LLR terms; and for each iteration, determining performance measurement results of the LDPC decoding means when decoding the respective code block using each respective set of the scaled LLR terms.

Another example (e.g. example 27) relates to a previously-described example (e.g. one or more of examples 21-26), wherein the performance measurement results of the LDPC decoding means comprise a number of LDPC decoder iterations needed to compute, using a respective set of scaled LLR terms, a corresponding code block that successfully passes an error checking process.

Another example (e.g. example 28) relates to a previously-described example (e.g. one or more of examples 21-27), wherein the predicted LDPC decoder control input comprises a predicted LLR scaling factor used to provide a respective set of scaled LLR terms that results in the LDPC decoding means maximizing a probability of successful decoding of a corresponding code block.

Another example (e.g. example 29) relates to a previously-described example (e.g. one or more of examples 21-28), wherein the error checking process includes a cyclic redundancy check (CRC) or a syndrome pass/fail error check.

An example (e.g. example 30) is directed to a non-transitory computer-readable medium having instructions stored thereon that, when executed by a processing means of a wireless device, cause the wireless device to: train an LDPC decoder control input model to predict LDPC decoder control inputs using (i) training data that is based upon previous log likelihood ratio (LLR) terms used by a LDPC decoding means, and (ii) performance measurement results of the LDPC decoding means using the previous LLR terms; and compute, via the trained LDPC decoder control input model at inference for a code block that is received subsequent to the previous LLR terms, a predicted LDPC decoder control input based upon estimated channel parameters corresponding to when the code block was received, wherein the LDPC decoding means decodes the code block using the predicted LDPC decoder control input, and wherein the processing means trains the LDPC decoder control input model during inactive decoding periods of the LDPC decoding means.

Another example (e.g. example 31), relates to a previously-described example (e.g. example 30), wherein the trained LDPC decoder control input model comprises a LLR scaling model that is configured to predict, as the predicted LDPC decoder control input, a predicted LLR scaling factor at inference for the code block that is received subsequent to the previous LLR terms, and wherein the LDPC decoding means decodes the code block using a set of scaled LLR terms that are generated using the predicted LLR scaling factor.

Another example (e.g. example 32) relates to a previously-described example (e.g. one or more of examples 30-31), wherein the instructions, when executed by the processing means, cause the wireless device to generate the training data by labelling the previous LLR terms.

Another example (e.g. example 33) relates to a previously-described example (e.g. one or more of examples 30-32), wherein the labelling of the previous LLR terms is based upon respective channel parameters corresponding to when the previous LLR terms were received.

Another example (e.g. example 34) relates to a previously-described example (e.g. one or more of examples 30-33), wherein the channel parameters comprise one or more of a multipath power delay profile, delay spread, doppler spread, an interference level, a location of a transmitting device, a numerology, a rank, or a Modulation Coding Scheme (MCS) index.

Another example (e.g. example 35) relates to a previously-described example (e.g. one or more of examples 30-34), wherein the instructions, when executed by the processing means, cause the wireless device to train the LDPC decoder control input model by: for each one of the previous LLR terms, iteratively applying a different scaling factor for decoding a respective code block to thereby generate a respective set of scaled LLR terms; and for each iteration, determining performance measurement results of the LDPC decoding means when decoding the respective code block using a respective set of the scaled LLR terms.

Another example (e.g. example 36) relates to a previously-described example (e.g. one or more of examples 30-35), wherein the performance measurement results of the LDPC decoding means comprise a number of LDPC decoder iterations needed to compute, using a respective set of scaled LLR terms, a corresponding code block that successfully passes an error checking process.

Another example (e.g. example 37) relates to a previously-described example (e.g. one or more of examples 30-36), wherein the predicted LDPC decoder control input comprises a predicted LLR scaling factor used to provide a respective set of scaled LLR terms that results in the LDPC decoding means maximizing a probability of successful decoding of a corresponding code block.

Another example (e.g. example 38) relates to a previously-described example (e.g. one or more of examples 30-37), wherein the error checking process includes a cyclic redundancy check (CRC) or a syndrome pass/fail error check.

An example (e.g. example 39) is directed to wireless device, comprising: a low-density parity check (LDPC) decoding means; and a processing means for executing instructions stored in a memory to: train a log likelihood ratio (LLR) scaling model to predict LLR scaling factors using (i) training data that is based upon previous LLR terms used by the LDPC decoding means, and (ii) performance measurement results of the LDPC decoding means using the previous LLR terms; and compute, via the trained LLR scaling model at inference for a code block that is received subsequent to the previous LLR terms, a predicted LLR scaling factor based upon estimated channel parameters corresponding to when the code block was received, wherein the LDPC decoding means decodes the code block using a set of scaled LLR terms that are generated using the predicted LLR scaling factor.

Another example (e.g. example 40), relates to a previously-described example (e.g. example 39), wherein the processing means trains the LLR scaling model by: for each one of the previous LLR terms, iteratively applying a scaling factor for decoding a respective code block to thereby generate a set of scaled LLR terms; and for each iteration, determining performance measurement results of the LDPC decoding means when decoding the respective code block using a respective set of scaled LLR terms.

An apparatus as shown and described.

A method as shown and described.

### Conclusion

The aforementioned description will so fully reveal the general nature of the disclosure that others can, by applying knowledge within the skill of the art, readily modify and/or adapt for various applications without undue experimentation, and without departing from the general concept of the present disclosure. Therefore, such adaptations and modifications are intended to be within the meaning and range of equivalents of the disclosed implementations, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

References in the specification to "one implementation," "an implementation," " an exemplary implementation," etc., indicate that the implementation described may include a particular feature, structure, or characteristic, but every implementation may not necessarily include the particular feature, structure, or characteristic. Moreover, such phrases are not necessarily referring to the same implementation. Further, when a particular feature, structure, or characteristic is described in connection with an implementation, it is submitted that it is within the knowledge of one skilled in the art to affect such feature, structure, or characteristic in connection with other implementations whether or not explicitly described.

The implementations described herein are provided for illustrative purposes, and are not limiting. Other implementations are possible, and modifications may be made to the described implementations. Therefore, the specification is not meant to limit the disclosure. Rather, the scope of the disclosure is defined only in accordance with the following claims and their equivalents.

The implementations described herein may be facilitated in hardware (e.g., circuits), firmware, software, or any combination thereof. Implementations may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others. Further, firmware, software, routines, instructions may be described herein as performing certain actions. However, it should be appreciated that such descriptions are merely for convenience and that such actions in fact results from computing devices, processors, controllers, or other devices executing the firmware, software, routines, instructions, etc. Further, any of the implementation variations may be carried out by a general purpose computer.

For the purposes of this discussion, the term "processing circuitry" or "processor circuitry" shall be understood to be circuit(s), processor(s), logic, or a combination thereof. For example, a circuit can include an analog circuit, a digital circuit, state machine logic, other structural electronic hardware, or a combination thereof. A processor can include a microprocessor, a digital signal processor (DSP), or other hardware processor. The processor can be "hard-coded" with instructions to perform corresponding function(s) according to implementations described herein. Alternatively, the processor can access an internal and/or external memory to retrieve instructions stored in the memory, which when executed by the processor, perform the corresponding function(s) associated with the processor, and/or one or more functions and/or operations related to the operation of a component having the processor included therein.

In one or more of the implementations described herein, processing circuitry can include memory that stores data and/or instructions. The memory can be any well-known volatile and/or non-volatile memory, including, for example, read-only memory (ROM), random access memory (RAM), flash memory, a magnetic storage media, an optical disc, erasable programmable read only memory (EPROM), and programmable read only memory (PROM). The memory can be non-removable, removable, or a combination of both.

## Claims

1. A wireless device, comprising:
a low-density parity check (LDPC) decoder; and
a processor configured to execute instructions stored in a memory to:
train an LDPC decoder control input model to predict LDPC decoder control inputs using (i) training data that is based upon previous log likelihood ratio (LLR) terms used by the LDPC decoder, and (ii) performance measurement results of the LDPC decoder using the previous LLR terms; and
compute, via the trained LDPC decoder control input model at inference for a code block that is received subsequent to the previous LLR terms, a predicted LDPC decoder control input based upon estimated channel parameters corresponding to when the code block was received,
wherein the LDPC decoder is configured to decode the code block using the predicted LDPC decoder control input, and
wherein the processor is configured to train the LDPC decoder control input model during inactive decoding periods of the LDPC decoder.

2. The wireless device of claim 1, wherein the processor is configured to generate the training data by labelling the previous LLR terms, and
wherein the labelling of the previous LLR terms is based upon respective channel parameters corresponding to when the previous LLR terms were received.

3. The wireless device of claim 1 or claim 2, wherein the trained LDPC decoder control input model comprises a LLR scaling model that is configured to predict, as the predicted LDPC decoder control input, a predicted LLR scaling factor at inference for the code block that is received subsequent to the previous LLR terms, and
wherein the LDPC decoder is configured to decode the code block using a set of scaled LLR terms that are generated using the predicted LLR scaling factor.

4. The wireless device of any one of claims 1-3, wherein the channel parameters comprise one or more of a multipath power delay profile, delay spread, doppler spread, an interference level, a location of a transmitting device, a numerology, a rank, or a Modulation Coding Scheme (MCS) index.

5. The wireless device of any one of claims 1-4, wherein the processor is configured to train the LDPC decoder control input model by:
for each one of the previous LLR terms, iteratively applying a different scaling factor for decoding a respective code block to thereby generate a respective set of scaled LLR terms; and
for each iteration, determining performance measurement results of the LDPC decoder when decoding the respective code block using each respective set of the scaled LLR terms.

6. The wireless device of claim 5, wherein the performance measurement results of the LDPC decoder comprise a number of LDPC decoder iterations needed to compute, using a respective set of scaled LLR terms, a corresponding code block that successfully passes an error checking process.

7. The wireless device of claim 6, wherein the error checking process includes a cyclic redundancy check (CRC) or a syndrome pass/fail error check.

8. The wireless device of any one of claims 1-7, wherein the predicted LDPC decoder control input comprises a predicted LLR scaling factor used to provide a respective set of scaled LLR terms that results in the LDPC decoder maximizing a probability of successful decoding of a corresponding code block.

9. A non-transitory computer-readable medium having instructions stored thereon that, when executed by a processor of a wireless device, cause the wireless device to:
train an LDPC decoder control input model to predict LDPC decoder control inputs using (i) training data that is based upon previous log likelihood ratio (LLR) terms used by a LDPC decoder, and (ii) performance measurement results of the LDPC decoder using the previous LLR terms; and
compute, via the trained LDPC decoder control input model at inference for a code block that is received subsequent to the previous LLR terms, a predicted LDPC decoder control input based upon estimated channel parameters corresponding to when the code block was received, wherein the LDPC decoder is configured to decode the code block using the predicted LDPC decoder control input, and
wherein the processor is configured to train the LDPC decoder control input model during inactive decoding periods of the LDPC decoder.

10. The non-transitory computer-readable medium of claim 9, wherein the instructions, when executed by the processor, cause the wireless device to generate the training data by labelling the previous LLR terms, and
wherein the labelling of the previous LLR terms is based upon respective channel parameters corresponding to when the previous LLR terms were received.

11. The non-transitory computer-readable medium of claim 9 or claim 10, wherein the trained LDPC decoder control input model comprises a LLR scaling model that is configured to predict, as the predicted LDPC decoder control input, a predicted LLR scaling factor at inference for the code block that is received subsequent to the previous LLR terms, and
wherein the LDPC decoder is configured to decode the code block using a set of scaled LLR terms that are generated using the predicted LLR scaling factor.

12. The non-transitory computer-readable medium of any one of claims 9-11, wherein the channel parameters comprise one or more of a multipath power delay profile, delay spread, doppler spread, an interference level, a location of a transmitting device, a numerology, a rank, or a Modulation Coding Scheme (MCS) index.

13. The non-transitory computer-readable medium of any one of claims 9-11, wherein the instructions, when executed by the processor, cause the wireless device to train the LDPC decoder control input model by:
for each one of the previous LLR terms, iteratively applying a different scaling factor for decoding a respective code block to thereby generate a respective set of scaled LLR terms; and
for each iteration, determining performance measurement results of the LDPC decoder when decoding the respective code block using a respective set of the scaled LLR terms.

14. The non-transitory computer-readable medium of claim 13, wherein the performance measurement results of the LDPC decoder comprise a number of LDPC decoder iterations needed to compute, using a respective set of scaled LLR terms, a corresponding code block that successfully passes an error checking process.

15. The non-transitory computer-readable medium of claim 14, wherein the predicted LDPC decoder control input comprises a predicted LLR scaling factor used to provide a respective set of scaled LLR terms that results in the LDPC decoder maximizing a probability of successful decoding of a corresponding code block.
